# EUROPEAN PATENT APPLICATION

(11) **EP 2 642 621 A1**
(43) Date of publication of application: **25.09.2013**
(21) Application number: 11840902.8
(22) Date of filing: 11.11.2011
(51) Int. Cl.: H01S 5/028, H01S 5/323

(54) **SEMICONDUCTOR LASER ELEMENT AND METHOD FOR MANUFACTURING SAME**

(30) Priority: 19.11.2010 JP 2010258883
(71) Applicant: Sony Corporation, Tokyo 108-0075 (JP)
(72) Inventor: TANGE, Takashi, Tokyo 108-0075 (JP); TOMIYA, Shigetaka, Miyagi 989-0734 (JP)
(74) Representative: Müller - Hoffmann & Partner
(86) International application number: PCT/JP2011/076115
(87) International publication number: WO 2012/067047

(57) **Abstract**

The present invention relates to a semiconductor laser device capable of reliably suppressing degradation of an end face due to interface oxidation and distortion application, and to a manufacturing method of the same.

The semiconductor laser device has a laser structure portion 107 having opposite resonator faces 108 and 109, and protecting films 110 and 120 formed on at least one of the opposite resonator end faces, wherein the protecting films 110 and 120 are formed of nitride dielectric films having a multistage structure including amorphous layers 111 and 121 and polycrystal layers 112 and 122 in crystal structure, respectively, from a side in contact with the resonator faces.

## Description

### Technical Field

The present invention relates to a semiconductor laser device having a protecting film of a specific structure on a resonator face, and to a manufacturing method of the same.

### Background Art

High-output compound semiconductor laser devices are in practical use, for example for writing onto optical disks or magneto-optical disks.

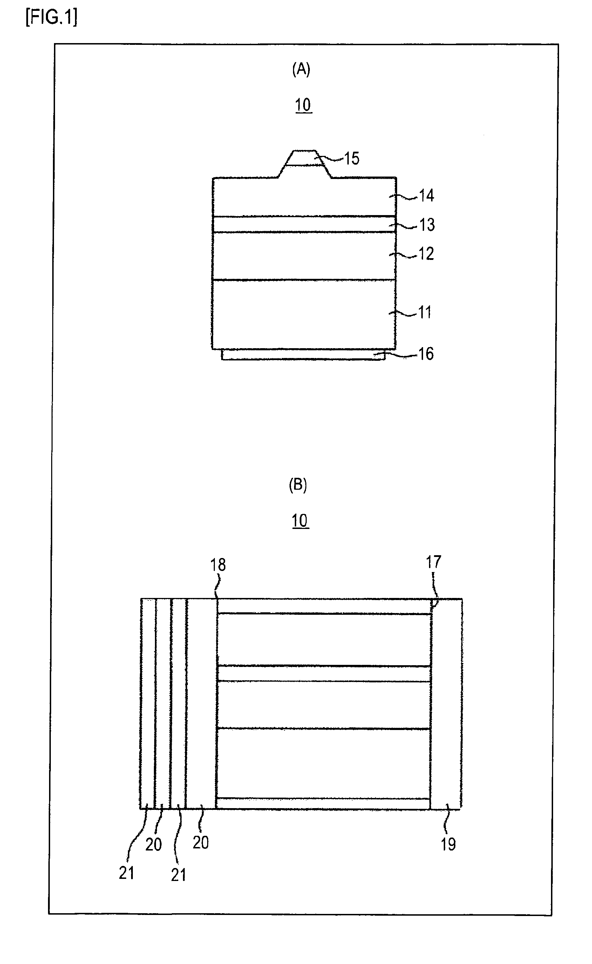

Fig. 1 (A) and Fig. 1 (B) are schematic section views showing the structure of a typical compound semiconductor laser device. Fig. 1(A) shows the structure in a vertical direction of laser stripes, and Fig. 1(B) shows the structure in a horizontal direction of the laser stripes.

A semiconductor laser device 10 in Fig. 1 has an n-type cladding layer 12, a quantum well light-emitting layer 13, and a p-type cladding layer 14 which are formed on a substrate 11. A p-electrode 15 and an n-electrode 16 are formed on the p-side and the n-side, respectively.
The semiconductor laser device 10 has a front end face 17 and a rear end face 18 which serve as opposite resonator faces. An end face protecting film is deposited on each of the front end face 17 and the rear end face 18.
A single layer of aluminum oxide film (Al₂O₃) 19 is deposited on the front end face (light exiting side end face) 17, and a multilayer film of aluminum oxide (Al₂O₃) 20 and titanium oxide (TiO₂) 21 is deposited on the rear end face (light reflecting side end face) 18, as the end face protecting film.

The compound semiconductor laser device as described above has suffered from the degradation of the end face due to an increase in operation current associated with a higher output. The results of studies have shown that damage to a light exiting portion contributes to sudden degradation.
The degradation of the light exiting portion is caused since a non-radiative recombination level formed at the interface between the semiconductor and the protecting film absorbs light and excessive heat is generated in the light exiting portion.
It is contemplated that principal factors in the occurrence of the non-radiative recombination level include oxidation of semiconductor, occurrence of crystal defects at the interface between the semiconductor and the protecting film and the like.

To address these problems, various techniques have been proposed for improvement by changing the material of the end face protecting film (see, for example, Patent Documents 1 to 7).

Patent Document 1 has disclosed a semiconductor laser device in which a protecting film structure has a porous film/dense film and SiN, BN, AlN, and GaN are used as a protecting film material.

Patent Document 2 has disclosed a semiconductor laser device in which a protecting film structure is a coaxial oriented crystal/different axis oriented crystal and a nitride is used as a protecting film material.

Patent Document 3 has disclosed a semiconductor laser device in which a protecting film structure is a single layer of different axis oriented crystal and a nitride is used as a protecting film material.

Patent Document 4 has disclosed a semiconductor laser device in which a protecting film structure is a hexagonal system structure and ZnO, AlN, GaN, and BN are used as a protecting film material.

Patent Document 5 has disclosed a semiconductor laser device in which a protecting film structure is partially amorphous and AlN is used as a protecting film material.

Patent Document 6 has disclosed a semiconductor laser device in which a protecting film structure is coaxial crystal, and Al-O-N and AlN are used as a protecting film material.

Patent Document 7 has disclosed a semiconductor laser device in which a protecting film structure is a crystalline film and Al1-x-y-zGaxInyBzN is used as a protecting film material.

### Related Art References

### Patent Documents

Patent Document 1: Japanese Patent No.3774503
Patent Document 2: JP-A-2008-182208
Patent Document 3: JP-A-2009-76858
Patent Document 4: JP-A-2006-203162
Patent Document 5: JP-A-2007-103814
Patent Document 6: JP-A-2007-273951
Patent Document 7: JP-A-2000-49410

### Summary of the Invention

### Problems that the Invention is to Solve

While the nitride material is used as the material of the end face protecting film in the proposed semiconductor laser devices as described above, various structure forms are employed for the film structure.
In these semiconductor laser devices, it is still difficult to reliably suppress the degradation of the end face due to interface oxidation and distortion application.

It is an object of the present invention to provide a semiconductor laser device capable of reliably suppressing degradation of an end face due to interface oxidation and distortion application, and a manufacturing method of the same. Means for Solving the Problems

According to a first aspect of the present invention, a semiconductor laser device includes a laser structure portion having opposite resonator faces, and a protecting film formed on at least one of the opposite resonator faces, wherein the protecting film is formed of a nitride dielectric film having a multistage structure including an amorphous layer and a polycrystal layer in crystal structure from a side in contact with the resonator face.

According to a second aspect of the present invention, a manufacturing method of a semiconductor laser device includes a first step of forming a laser structure portion having a opposite resonator faces, and a second step of forming a protecting film on at least one of the opposite resonator faces, wherein the protecting film is formed of a nitride dielectric film having a multistage structure including an amorphous layer and a polycrystal layer in crystal structure from a side in contact with the resonator face.

### Advantage of the Invention

According to the present invention, it is possible to reliably suppress the degradation of the end face due to interface oxidation and distortion application.

### Brief Description of the Drawings

[Fig. 1] Schematic section views showing the structure of a typical compound semiconductor laser device.
[Fig. 2] Schematic section views showing the structure of a compound semiconductor laser device according to an embodiment of the present invention.
[Fig. 3] A diagram showing a section image of an AlN protecting film onto a GaAs semiconductor end face with a bright field STEM (Scanning Transmission Electron Microscope).
[Fig. 4] A section image of the AlN protecting film onto the GaAs semiconductor end face with a bright field TEM (Transmission Electron Microscope) and an electronic diffraction image.
[Fig. 5] A diagram showing the relationship between the band gaps of compound semiconductors and the lattice mismatching of wurtzite type AlN.
[Fig. 6] A diagram showing a high-resolution TEM image of an end face AlN for a GaN compound semiconductor.
[Fig. 7] A diagram showing the relationship between the laser operation time and the laser output degradation rate in the semiconductor laser device having the end face protecting film.
[Fig. 8] A diagram showing TEM images of distortion due to AlN coat films in a GaN-based semiconductor and an AlGaInP-based semiconductor.

### Mode for Carrying Out the Invention

An embodiment of the present invention will hereinafter be described with reference to the drawings.
The description is made in the following order.
1. Structure example of semiconductor laser device
2. TEM image analysis
3. Identification method of hexagonal system
4. Evaluation of operation time of semiconductor laser device having end face protecting film

### <Structure example of semiconductor laser device>

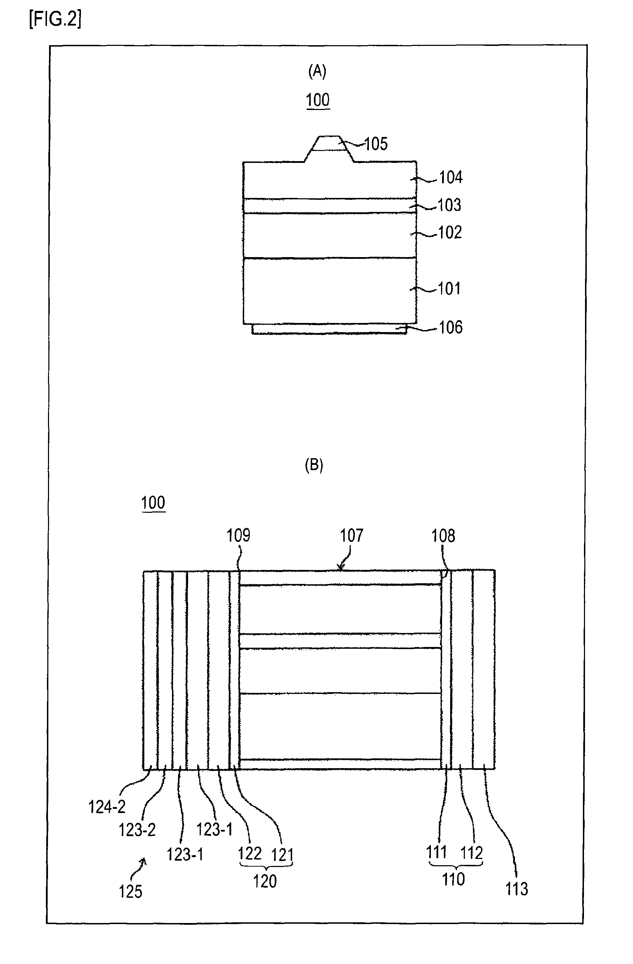

Fig. 2 (A) and Fig. 2 (B) are schematic section views showing the structure of a compound semiconductor laser device according to an embodiment of the present invention. Fig. 2(A) shows the structure in a vertical direction of laser stripes. Fig. 2(B) shows the structure in a horizontal direction of the laser stripes.

A semiconductor laser device 100 in Fig. 2 has an n-type cladding layer 102, a quantum well light-emitting layer 103, and a p-type cladding layer 104 which are formed on a substrate 101. A p-electrode 105 and an n-electrode 106 are formed on the p-side and the n-side, respectively.
The semiconductor laser device 100 has a front end face (first end face) 108 and a rear end face (second end face) 109 which form a laser structure portion 107 as a resonator and serve as opposite resonator faces. An end face protecting film is deposited on each of the front end face 108 and the rear end face 109.
The front end face corresponds to the first end face and the rear end face corresponds to the second end face.

In the semiconductor laser device 100 according to the present embodiment, a first dielectric protecting film 110 provided by stacking an amorphous nitride film 111 and polycrystal nitride film 112 from the side of the end face 108 is formed as the end face protecting film on the front end face (light exiting side end face) 108.
A second dielectric protecting film 120 provided by stacking an amorphous nitride film 121 and a polycrystal nitride film 122 from the side of the end face 109 is formed on the rear end face (light reflecting side end face) 109, similarly to the side of the front end face.
For example, aluminum nitride AlN is used for the first dielectric protecting film 110 and the second dielectric protecting film 120.
Such an amorphous layer may contain microcrystal.

In this manner, in the present embodiment, the amorphous nitride films 111 and 121 are formed in contact with the front end face 108 and the rear end face 109, respectively, of the laser structure portion 107 serving as the resonator, and the polycrystal nitride films 112 and 122 are formed over the amorphous nitride films 111 and 121, respectively.
Since the amorphous nitride films 111 and 121 are formed in contact with the front end face 108 and the rear end face 109, respectively, supply of oxygen to semiconductor is eliminated to suppress oxidation of a semiconductor interface, and distortion application to the semiconductor interface is reduced due to the amorphous film.
Each of the amorphous nitride films 111 and 121 is formed to have a film thickness set to 5 nm or smaller, for example.

The semiconductor laser device 100 has a third dielectric protecting film 113 made of oxide or nitride deposited on the side of the front end face 108 in order to protect the first dielectric protecting film 110. Specifically, the third dielectric protecting film 113 is formed on the side of the polycrystal nitride film 112 of the first dielectric protecting film 110 opposite to the side in contact with the amorphous nitride film 111.
On the side of the rear end face 109, a multilayer structure film 125 is formed which includes dielectric films 123-1 and 123-2 made of oxide or nitride and titanium oxide (TiO₂) films 124-1 and 124-2.
Specifically, on the side of the rear end face 109, the multilayer structure film 125 provided by repeatedly stacking the dielectric films as a multilayer is formed on the side of the second dielectric protecting film 120 in contact with the polycrystal layer 122. Specifically, the multilayer structure film 125 is formed on the side of the polycrystal nitride film 122 of the second dielectric protecting film 120 opposite to the side in contact with the amorphous nitride film 121.
For example, silicon oxide (SiO₂) or aluminum oxide (Al₂O₃) is used as the dielectric films 123-1 and 123-2.

An example of a manufacturing method of the semiconductor laser device 10 is now described.
For example, as shown in Fig. 2(A), the n-InGaP cladding layer 102 in lattice matching with GaAs is formed over the n-type (for example, GaAs) substrate 101 with a GaAs buffer layer (not shown) interposed between them.
Next, the quantum well light-emitting layer 103 is formed of an In1-xGaxAsyP1-y barrier layer and an InzGa1-zAs quantum well layer.
In addition, the p-InGaP cladding layer 104 in lattice matching with the GaAs substrate, a p-GaAs optical waveguide layer, and a p-GaAs cap layer are formed.
These layers are sequentially formed with an MOVPE method, or a gas source MBE method, or a CBE method.
Next, a ridge is formed, for example by using an oxide film as a mask, through a photoetching process. Any method can be used in the etching such as wet etching, RIE, or RIBE.
The etching is performed to stop at some point in the p-InGaP cladding layer 104 such that the p-GaAs optical waveguide layer is completely removed and the quantum well light-emitting layer 103 is not reached.
Next, the oxide film used as the etching mask is used as a mask for selective growth to perform the selective growth of an n-InGaP current confined layer (not shown) with the MOVPE method.
Then, the wafer is taken from a growth furnace, and the oxide film used as the selective growth mask is removed through etching. Next, a p-GaAs contact layer is formed with the MOVPE method or the MBE method.
After the p-side ohmic electrode 105 and the n-side ohmic electrode 106 are formed, the laser device is obtained with a predetermined resonator length by a cleavage method.

Then, as shown in Fig. 2(B), the AlN protecting films 110 and 120 are deposited.
The deposition of the AlN films is achieved by using an Al target and performing DC sputtering in an Ar and N2 gas atmosphere.
The present invention is not limited to this manufacturing method. It is possible to use an RF sputtering method with an Al target or an AlN target, an ECR sputtering method, an EB evaporation method or the like without limitation on the manufacturing method.
Then, the third dielectric film 113 is deposited as the protecting film for the first dielectric protecting film 110 on the side of the front end face 108.
The multilayer structure film 125 of SiO₂ and TiO₂ is deposited as the protecting film for the first dielectric protecting film 110 on the side of the rear end face 109.

### <2. TEM image analysis>

The GaAs semiconductor end face portion of the semiconductor laser device 100 manufactured as described above is analyzed.

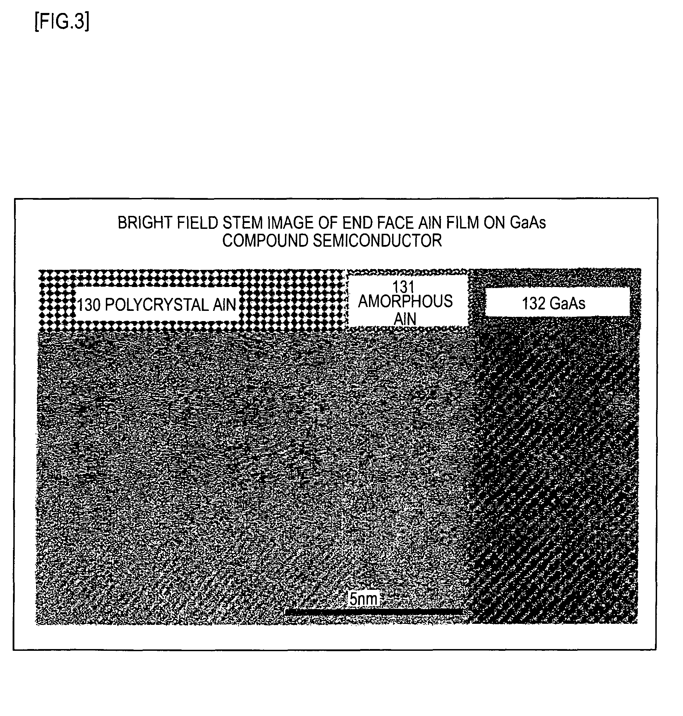

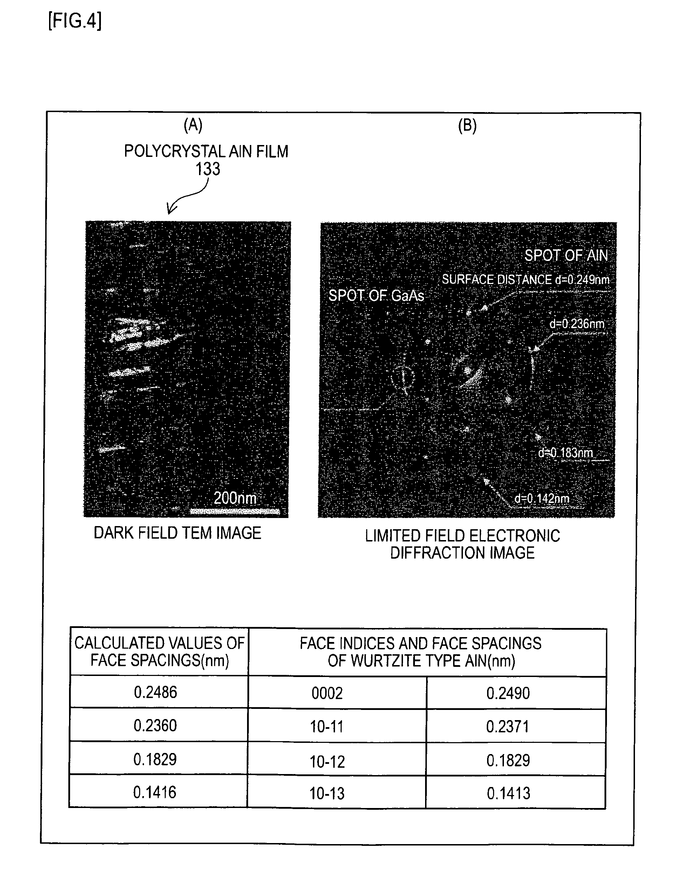

Fig. 3 and Fig. 4 are diagrams showing section TEM images of the AlN protecting film onto the GaAs semiconductor end face.
Fig. 3 shows a section image of the AlN protecting film onto the GaAs semiconductor end face with a bright field STEM (Scanning Transmission Electron Microscope).
Fig. 4(A) shows a section image of the AlN protecting film onto the GaAs semiconductor end face with a bright field TEM (Transmission Electron Microscope), and Fig. 4(B) shows an electronic diffraction image.

In Fig. 3, it was shown that the amorphous AlN film 131 of approximately 3 nm was formed at the interface of the GaAs semiconductor 130 and the polycrystal AlN film 132 was formed on the surface layer.
In Fig. 4, the crystal structure of the polycrystal AlN film 133 was identified as the hexagonal structure (wurtzite type).

### <3. Identification method of hexagonal system>

The identification method of the crystal structure of the polycrystal AlN film as the hexagonal structure (wurtzite type) is described.
Reference is made to Table 1 showing the face spacings of the AlN crystal structure and the measured values of the face spacings of the end face AlN film.

Possible crystal structures of the AlN crystal are a zinc blende type (cubic system) and the wurtzite type (hexagonal system). The crystal structure was identified from the comparison between literature values of the face spacings and the face spacings of the measured sample in each of the structures.
As shown in Table 1, the measured face spacings are in good agreement with those of the wurtzite type (hexagonal system), so that the polycrystal AlN in the present coat film was identified as the hexagonal system.

**[Table 1]**

| Face spacings of AlN crystal structure and measured values of face spacings of end face AlN film | | | |
|---|---|---|---|
| Crystal face | Zinc blende type (cubic system) | Wurtzite type (hexagonal system) | Measured values of face spacings |
| 10-10 | | 0.269500 | |
| 0002 | | 0.249000 | 0.2486 |
| 10-11 | | 0.237100 | 0.2360 |
| 111 | 0.233460 | | |
| 200 | 0.202260 | | |
| 10-12 | | 0.182900 | 0.1829 |
| 110 | | 0.155590 | |
| 220 | 0.143000 | | |
| 10-13 | | 0.141330 | 0.1416 |
| 200 | | 0.134750 | |
| 311 | 0.121950 | | |

| | | | |
|---|---|---|---|
| *1 Reference Proc. Jpn. Acad., Ser. B, volume 66 page 7 (1990) *2 Reference Natl. Bur. Stand. (U.S.) Monogr. 25, volume 12, page 5 (1975) | | | |

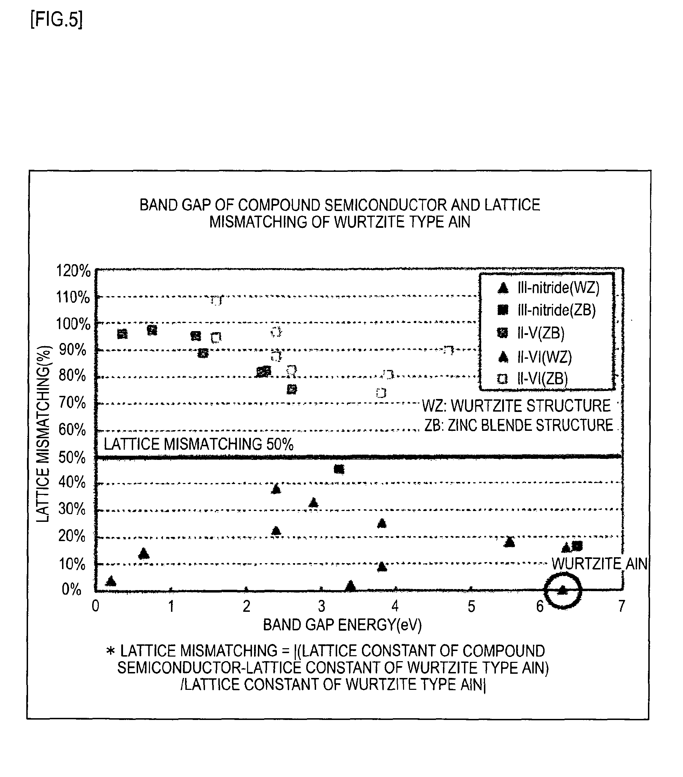

Fig. 5 is a diagram showing the relationship between the band gaps of compound semiconductors and the lattice mismatching of wurtzite type AlN.

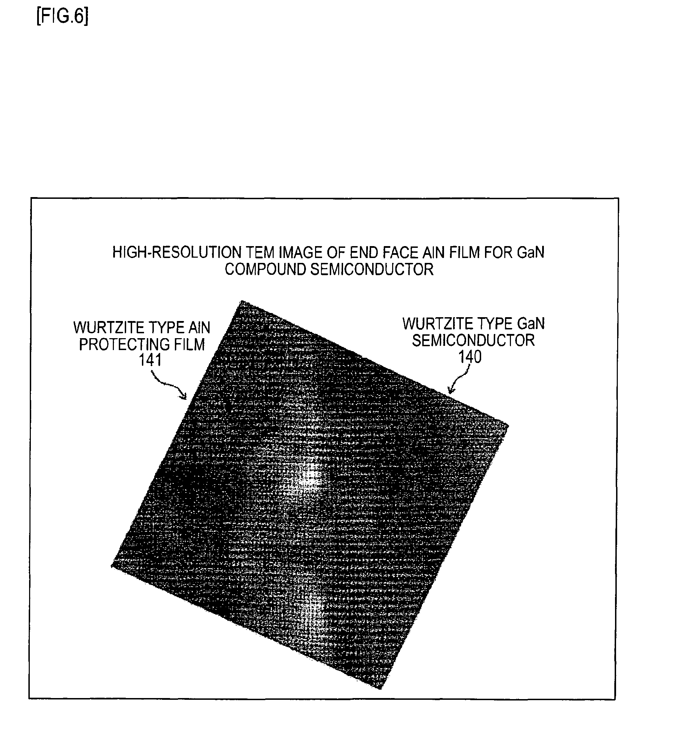

Fig. 6 is a diagram showing a high-resolution TEM image of an end face AlN for a GaN compound semiconductor.
In Fig. 5, the horizontal axis represents the band gap energy and the vertical axis represents the lattice mismatching.

The embodiment of the present invention is applied on condition that the absolute value of lattice mismatching between the lattice constant a of the compound semiconductor and the lattice constant a in the nitride polycrystal film is 50% or higher.
When AlN is used for the protecting film, the compound semiconductors having the zinc blende structure are the subjects of interest (except a nitride semiconductor) as shown in Fig. 5.
When the lattice mismatching between the semiconductor and the protecting film is 50% or lower, for example when an AlN protecting film 141 is deposited on a GaN semiconductor 140 (with a lattice mismatching of 2%) as shown in Fig. 6, any amorphous structure is not formed on the semiconductor end face but an epitaxial layer is grown.
Thus, distortion is applied to the semiconductor side.

### <4. Evaluation of operation time of semiconductor laser device having end face protecting film>

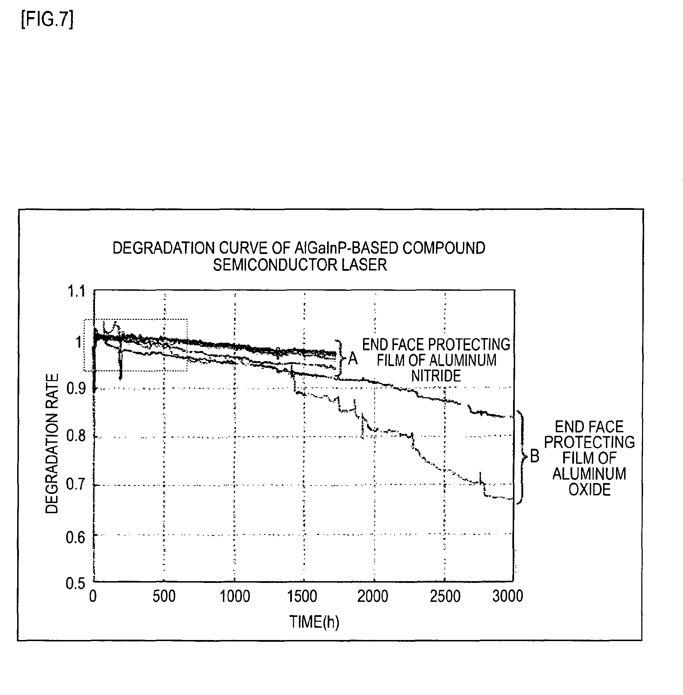

Fig. 7 is a diagram showing the relationship between the laser operation time and the laser output degradation rate in the semiconductor laser device having the end face protecting film.
An AlGaInP compound semiconductor laser is used in this case.
In Fig. 7, the horizontal axis represents the laser operation time, and the vertical axis represents the laser output degradation rate.
In Fig. 7, a group of lines shown by A represents the characteristics when aluminum nitride (AlN) is used as the end face protecting film, and a group of lines shown by B represents the characteristics when aluminum oxide (alumina: Al₂O₃) is used as the end face protecting film.

The thicknesses of the protecting film and the like of the semiconductor laser device as a prototype are described below. On the front side of the semiconductor laser device 10 according to the present embodiment, the semiconductor/AlN has a film thickness of 205 nm. On the rear side, the semiconductor/AlN has a film thickness of 79 nm.
TiO₂ has a film thickness of 63 nm and SiO₂ has a film thickness of 110.5 nm on the rear side. The multilayer film is deposited four times repeatedly. In addition, a multilayer structure film including TiO₂ having a film thickness of 63 nm and SiO₂ having a film thickness of 221 nm is deposited.
As apparent from Fig. 7, the prototype laser with the AlN coat film according to the present embodiment achieves the effect of suppressing the degradation as compared with the conventional laser with the alumina coat film.

The semiconductor laser device 100 according to the present embodiment employs the nitride protecting film to eliminate supply of oxygen to the semiconductor to allow the suppression of oxidation at the semiconductor interface, in contrast to the oxide protecting film.

In addition, the protecting film in contact with the semiconductor is amorphous in the semiconductor laser device 100 according to the present embodiment, so that the distortion application to the semiconductor interface is reduced. For a semiconductor laser device having a window structure of an active layer thickness modulation type or the like, any negative influence on the window structure effect can be suppressed.

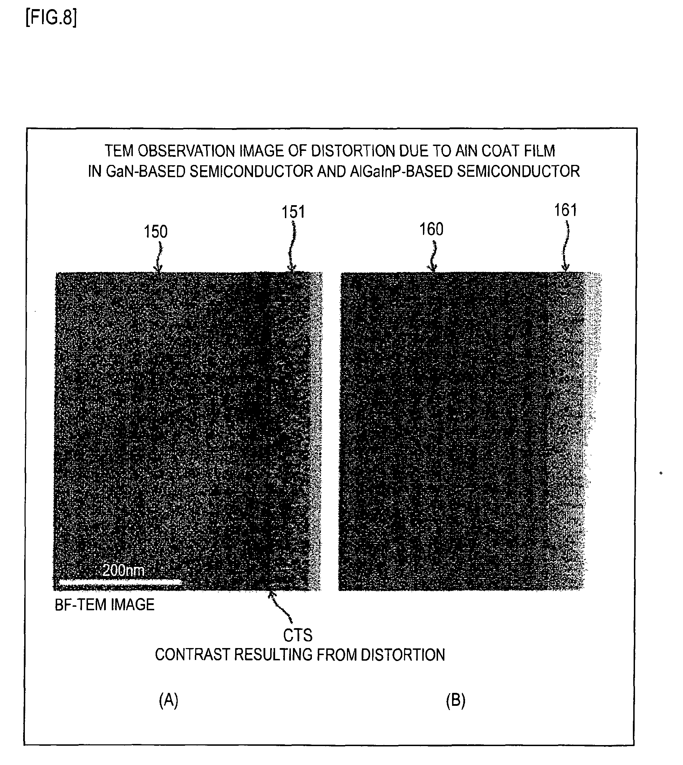

Fig. 8(A) and Fig. 8(B) are diagrams showing TEM images of distortion due to the AlN coat films in a GaN-based semiconductor and an AlGaInP-based semiconductor.
Fig. 8 (A) shows the TEM image when an AlN coat of polycrystal single layer is deposited directly on the end face of the GaN-based semiconductor.
Fig. 8(B) shows the TEM image when an AlN coat film of two-stage, amorphous and polycrystal, structure is deposited on the end face of the AlGaInP-based semiconductor.

As shown in the TEM image of Fig. 8(A), when the AlN coat film of polycrystal single layer 151 is deposited directly on the end face of the GaN-based semiconductor 150, a contrast CTS resulting from distortion is observed on the semiconductor side.
In contrast, as shown in the TEM image of Fig. 8(B), when the AlN coat film of two-stage, amorphous and polycrystal, structure 161 is deposited on the end face of the AlGaInP-based semiconductor 160, no contrast resulting from distortion is observed.

As described above, in the semiconductor laser device 100 according to the present embodiment, the first dielectric protecting film 110 provided by stacking the amorphous nitride film 111 and the polycrystal nitride film 112 from the side of the M end face 108 is formed as the end face protecting film on the front end face (light exiting side end face) 108 in the semiconductor laser device 100 according to the present embodiment.
The second dielectric protecting film 120 provided by stacking the amorphous nitride film 121 and the polycrystal nitride film 122 from the side of the end face 109 is formed on the rear end face (light reflecting side end face) 109, similarly to the side of the front end face.
In this manner, in the semiconductor laser device 100 according to the present embodiment, the amorphous nitride films 111 and 121 are formed in contact with the front end face 108 and the rear end face 109 of the resonator 107, respectively, and the polycrystal nitride films 112 and 122 are formed over the amorphous nitride films 111 and 121, respectively.
Since the amorphous nitride films 111 and 121 are formed in contact with the front end face 108 and the rear end face 109, respectively, the supply of oxygen to the semiconductor is eliminated to suppress the oxidation of the semiconductor, and the distortion application to the semiconductor interface is reduced due to the amorphous film.
As a result, the oxidation of the semiconductor interface can be suppressed. For the semiconductor laser device having the window structure of the active layer thickness modulation type or the like, any negative influence to the window structure effect can be suppressed.
Thus, in the present embodiment, the nitride dielectric protecting film having the two-stage structure consisting of the amorphous layer and the polycrystal layer from the side of the semiconductor interface is used as the protecting film for the light exiting face in order to suppress the degradation of the end face in the high-output semiconductor laser. This can realize the semiconductor laser with high reliability in which the degradation of the end face due to the interface oxidation and the distortion application is suppressed.

The embodiment described above has shown the example in which the nitride dielectric protecting films 110 and 120 having the two-stage structure consisting of the amorphous layer and the polycrystal layer are placed on the front end face 108 and the rear end face 109 of the laser structure portion 107 including the resonator.
While this structure can achieve the optimum effect, it is possible to suppress the degradation of the end face due to the interface oxidation and the distortion application by the configuration in which the nitride dielectric protecting film is placed on one of the front end face 108 and the rear end face 109 of the laser structure portion 107.

### Description of Reference Numerals and Signs

100...compound semiconductor laser device, 101...semiconductor substrate, 102...n-type cladding layer, 103...quantum well light-emitting layer, 104...p-type cladding layer, 105...p-side, 106...n-electrode 106, 107...resonator, 108...front end face, 109...rear end face, 110...first dielectric protecting film, 111...amorphous nitride film, 112...polycrystal nitride film, 113...third dielectric film, 120...second dielectric protecting film, 121...amorphous nitride film, 122...polycrystal nitride film, 123-1, 123-2...dielectric film, 124-1, 124-2...titanium oxide (TiO₂) film.

## Claims

1. A semiconductor laser device comprising:
a laser structure portion having opposite resonator end faces; and
a protecting film formed on at least one of the opposite resonator end faces,
wherein the protecting film is formed of a nitride dielectric film having a multistage structure including an amorphous layer and a polycrystal layer in crystal structure from a side in contact with the resonator end face.

2. The semiconductor laser device according to claim 1, wherein the polycrystal layer of the protecting film has a hexagonal system crystal structure.

3. The semiconductor laser device according to claim 2, wherein lattice mismatching between a lattice constant a of a semiconductor and a lattice constant a of the hexagonal crystal structure in the protecting film is 50% or higher.

4. The semiconductor laser device according to any one of claims 1 to 3, wherein the protecting film contains a nitride material having a band gap energy higher than that of an active layer.

5. The semiconductor laser device according to any one of claims 1 to 4, wherein the protecting film is formed on a first end face on a light exiting side, and
a dielectric protecting film is formed on a side of the polycrystal layer of the protecting film opposite to a side in contact with the amorphous layer.

6. The semiconductor laser device according to any one of claims 1 to 5, wherein the protecting film is formed on a second end face on a light reflecting side opposite to the first end face on the light reflecting side, and
a multilayer structure film provided by repeatedly stacking a dielectric film as a multilayer on a side of the polycrystal layer of the protecting film opposite to a side in contact with the amorphous layer.

7. A manufacturing method of a semiconductor laser device comprising:
a first step of forming a laser structure portion having a opposite resonator faces; and
a second step of forming a protecting film on at least one of the opposite resonator faces,
wherein the protecting film is formed of a nitride dielectric film having a multistage structure including an amorphous layer and a polycrystal layer in crystal structure from a side in contact with the resonator face.

8. The manufacturing method of the semiconductor laser device according to claim 7, wherein the polycrystal layer of the protecting film has a hexagonal system crystal structure.

9. The manufacturing method of the semiconductor laser device according to claim 8, wherein lattice mismatching between a lattice constant a of a semiconductor and a lattice constant a of the hexagonal crystal structure in the protecting film is 50% or higher.

10. The manufacturing method of the semiconductor laser device according to any one of claims 7 to 9, wherein the protecting film contains a nitride material having a band gap energy higher than that of an active layer.
